# EUROPEAN PATENT APPLICATION

(11) **EP 4 344 169 A1**
(43) Date of publication of application: **27.03.2024**
(21) Application number: 22909212.7
(22) Date of filing: 29.06.2022
(51) Int. Cl.: H04L 69/08

(54) **MAGNETIC RESONANCE SCANNING PROTOCOL CONFIGURATION METHOD AND SYSTEM**

(30) Priority: 21.12.2021 CN 202111571628
(71) Applicant: Wuhan United Imaging Life Science Instrument Co., Ltd, Wuhan, Hubei 430206 (CN)
(72) Inventor: ZOU, Rui, Wuhan, Hubei 430206 (CN); ZHOU, Jianfan, Shanghai 201807 (CN); XU, Danrui, Wuhan, Hubei 430206 (CN)
(74) Representative: Wang, Bo
(86) International application number: PCT/CN2022/102132
(87) International publication number: WO 2023/115880

(57) **Abstract**

Embodiments of the present disclosure provide a method and a system for configuring an MR scanning protocol, wherein after determining a first gradient coil type currently connected to the MR device and at least one second gradient coil type applicable to an initial scan protocol input by a user, a target scanning protocol is determined based on the first gradient coil type, the at least one second gradient coil type, and the initial scan protocol.

## Description

### CROSS-REFERENCE TO RELATED APPLICATIONS

This application claims the priority of Chinese Patent Application No. 202111571628.3, filed on December 21, 2021, the entire contents of which are hereby incorporated by reference.

### TECHNICAL FIELD

The present disclosure relates to the field of magnetic resonance (MR), and in particular to methods and systems for configuring MR scanning protocols.

### BACKGROUND

With the advancement of MR technology, it has been widely used in various fields such as physics, chemistry, biology, and medicine, becoming one of the technologies for analyzing biological structures and diagnosing medical conditions. Different types of gradient coils may be used for scans of different anatomical regions and/or with different precision requirements.

In current practices, when a user wants to change a gradient coil, a technician from a manufacturer is required to be on-site for assistance. Specifically, the technician must be present to replace the gradient coil, and after the replacement, the technician needs to configure a scan parameter via a configuration management interface of an MR system. A configured scanning parameter tailored to the replaced gradient coil is then stored in the system to prevent accelerated wear or direct damage to the gradient coil caused by improper scanning parameters.

However, the manual configuration of the scanning parameter in this process is cumbersome and requires a certain level of expertise. It not only incurs high labor costs but also results in inefficient operations.

### SUMMARY

Embodiments of the present disclosure provide a method for configuring an MR scanning protocol. The method includes determining a first gradient coil type of a first gradient coil currently connected to an MR device; determining, based on an initial scanning protocol input by a user, at least one second gradient coil type applicable to the initial scanning protocol; and determining a target scanning protocol based on the first gradient coil type, the at least one second gradient coil type, and the initial scanning protocol.

In some embodiments, the target scanning protocol may be determined through operations including: determining whether the first gradient coil type is included in the at least one second gradient coil type, and in response to determining that the first gradient coil type is included in the at least one second gradient coil type, determining the initial scanning protocol as the target scanning protocol.

In some embodiments, the target scanning protocol may be determined through operations including: determining whether the first gradient coil type is included in the at least one second gradient coil type, in response to determining that the first gradient coil type is not included in the at least one second gradient coil type, generating an intermediate scanning protocol based on the first gradient coil type, and obtaining the target scanning protocol by converting, based on the intermediate scanning protocol, the initial scanning protocol.

In some embodiments, the intermediate scanning protocol may be determined through operations including: determining a calibration value of a system parameter corresponding to the first gradient coil type, and generating the intermediate scanning protocol by determining, based on the calibration value of the system parameter, the first parameter range of each of the at least one scanning parameter.

In some embodiments, the intermediate scanning protocol may be determined through operations including: obtaining at least one reference protocol corresponding to the first gradient coil type, the at least one reference protocol including a reference range of each of the at least one scanning parameter, and generating the intermediate scanning protocol by determining, based on the reference range of each of the at least one scanning parameter, the first parameter range of each of the at least one scanning parameter.

In some embodiments, the intermediate scanning protocol may include a first parameter range of each of at least one scanning parameter, the initial scanning protocol may include a second parameter range of each of the at least one scanning parameter, and the target scanning protocol may be obtained through a conversion process including the following operations: for each of the at least one scanning parameter, determining an intersection range between the first parameter range and the second parameter range of the scanning parameter, and obtaining the target scanning protocol by updating, based on at least one intersection range of the at least one scanning parameter, the initial scanning protocol.

In some embodiments, the method may further include controlling the MR device to scan a target object according to the target scanning protocol.

In some embodiments, the scanning process may include obtaining a pre-stored calibration value of a system parameter corresponding to the first gradient coil type, updating the system parameter of the MR device based on the calibration value of the system parameter, and controlling the MR device whose system parameter has been updated to scan the target object according to the target scanning protocol.

Embodiments of the present disclosure provide a system for configuring an MR scanning protocol. The system may include at least one storage device configured to store one or more instructions for configuring the MR scanning protocol and at least one processor in communication with the at least one storage device. When executing the one or more instructions, the at least one processor is configured to direct the system to perform operations including: determining a first gradient coil type of a first gradient coil currently connected to an MR device; determining, based on an initial scanning protocol input by a user, at least one second gradient coil type applicable to the initial scanning protocol; and determining a target scanning protocol based on the first gradient coil type, the at least one second gradient coil type, and the initial scanning protocol.

Embodiments of the present disclosure provide a non-transitory computer-readable storage medium which stores one or more computer instructions. When the one or more instructions are read from the storage medium, a computer executes the method for configuring an MR scanning protocol according to any embodiments of the present disclosure.

### BRIEF DESCRIPTION OF THE DRAWINGS

The present disclosure is further illustrated by way of exemplary embodiments, which are described in detail through the accompanying drawings. These embodiments are not limiting, and in these embodiments, a same numbering indicates a same structure, wherein:
FIG. 1 is a schematic diagram of a magnetic resonance imaging (MRI) system according to some embodiments of the present disclosure;
FIG. 2 is an exemplary block diagram of a computing device according to some embodiments of the present disclosure;
FIG. 3 is an exemplary module diagram of a system for configuring an MR scanning protocol according to some embodiments of the present disclosure;
FIG. 4 is an exemplary flowchart of a method for configuring an MR scanning protocol according to some embodiments of the present disclosure;
FIG. 5 is an exemplary flowchart of a process for determining a target scanning protocol according to some embodiments of the present disclosure;
FIG. 6 is an exemplary flowchart of a process for controlling an MR device to scan a target object according to a target scanning protocol in some embodiments of the present disclosure; and
FIG. 7 is a schematic diagram of a workflow of an MR device according to some embodiments of the present disclosure.

### DETAILED DESCRIPTION

In order to more clearly illustrate the technical solutions of the embodiments of the present disclosure, the accompanying drawings for the description of the embodiments are described below. Obviously, the accompanying drawings in the following description are only some examples or embodiments of the present disclosure, and it is possible for a person of ordinary skill in the art to apply the present disclosure to other similar scenarios in accordance with these accompanying drawings without creative labor. Unless obviously obtained from the context or the context illustrates otherwise, the same numeral in the drawings refers to the same structure or operation.

It should be understood that the terms "system," "device," "unit," and/or "module" are used herein as a way to distinguish between different components, elements, parts, sections, or assemblies at different levels. However, if other words may achieve the same purpose, the terms may be replaced with alternative expressions.

As indicated in the present disclosure and in the claims, unless the context clearly suggests an exception, the words "one," "a," "a kind of," and/or "the" do not refer specifically to the singular but may also include the plural. In general, the terms "include" and "comprise" suggest only the inclusion of clearly identified steps and elements, which do not constitute an exclusive list, and the method or device may also include other steps or elements.

The present disclosure uses flowcharts to illustrate the operations performed by the system according to some embodiments of the present disclosure. It should be understood that the operations described herein are not necessarily executed in a specific order. Instead, they may be executed in reverse order or simultaneously. Additionally, other operations may be added to these processes or certain steps may be removed.

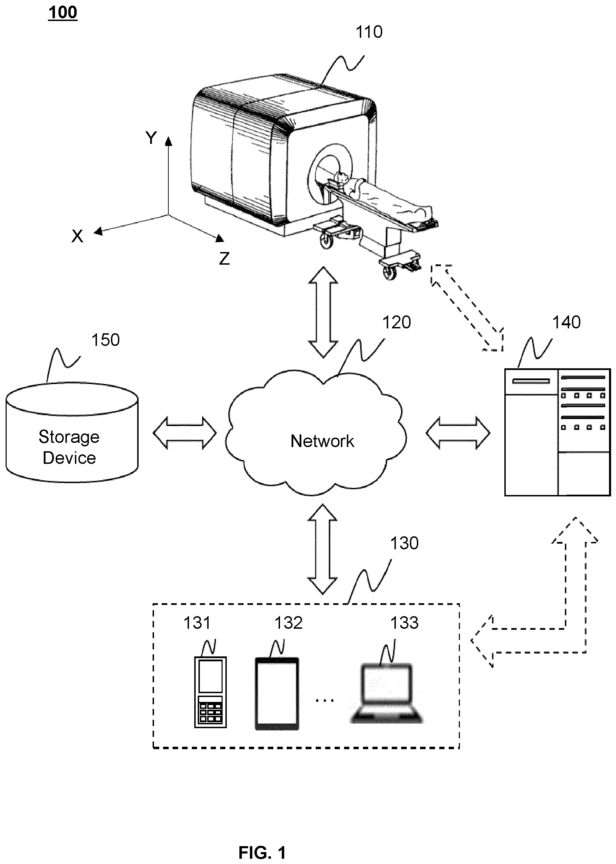

FIG. 1 is a schematic diagram of an MRI system according to some embodiments of the present disclosure.

As shown in FIG. 1, an MRI system 100 may include an MRI scanner 110, a network 120, at least one terminal 130, a processing device 140, and a storage device 150. The components of the MRI system 100 may be connected to each other in various ways. For example, as shown in FIG.1, the MRI scanner 110 may be connected to the processing device 140 via the network 120. As another example, the MRI scanner 110 may be directly connected to the processing device 140, as indicated by the bidirectional dashed arrow connecting the MRI scanner 110 and the processing device 140. As yet another example, the storage device 150 may be directly connected to the processing device 140 or connected through the network 120. As still another example, the at least one terminal 130 (e.g., terminal 131, terminal 132, terminal 133, etc.) may be directly connected to the processing device 140, as indicated by the bidirectional dashed arrows connecting the terminals 130 and the processing device 140, or connected to the processing device 140 via the network 120.

The MRI scanner 110 can scan an object located within its detection region and generate scan data related to the object. In the present disclosure, the terms "object" and "subject" are used interchangeably. For example, the object may include a patient, an artificial object, etc. As another example, the object may include a specific part of the patient, such as an organ and/or tissue. For instance, the object may include the head, brain, neck, body, shoulders, arms, chest, heart, stomach, blood vessels, soft tissues, knees, feet, or any combination thereof. In some embodiments, the MRI scanner 110 may be a high-field MRI scanner, a midfield MRI scanner, a low-field MRI scanner, etc. In the present disclosure, the X-axis, Y-axis, and Z-axis shown in FIG. 1 form an orthogonal coordinate system. In the exemplary embodiment shown in FIG.1, the X-axis and Z-axis are horizontal, while the Y-axis is vertical. As illustrated in the figure, a positive X direction along the X-axis is from the right side to the left side of the MRI scanner 110 when facing the front side of the MRI scanner 110; a positive Y direction along the Y-axis is from the bottom to the top of the MRI scanner 110; and a positive Z direction along the Z-axis indicates a direction in which the object moves out of a scanning channel (or referred to as a bore) of the MRI scanner 110.

In some embodiments, the MRI scanner 110 may include a main magnet, a gradient coil (also referred to as a spatial encoding coil), a radiofrequency (RF) coil, etc. Since the present disclosure primarily involves the gradient coil, a detailed description of the gradient coil is provided below. The gradient coil may be located within the main magnet and generate gradient magnetic fields, including a gradient magnetic field Gₓ, a gradient magnetic field G_{y}, and a gradient magnetic field G_{z}. These gradient magnetic fields may be superimposed on a main magnetic field generated by the main magnet, distorting the main magnetic field. As a result, a magnetic orientation of a proton in the object may vary based on a position of the proton in the gradient magnetic fields, encoding spatial information into an MR signal (e.g., an echo signal) generated by an imaged region of the object. The gradient coil may further include an X coil (e.g., for generating the gradient magnetic field Gₓ corresponding to the X direction), a Y coil (e.g., for generating the gradient magnetic field G_{y} corresponding to the Y direction), and/or a Z coil (e.g., for generating the gradient magnetic field G_{z} corresponding to the Z direction) (the X, Y, and Z coils are not shown in FIG.1).

In certain situations, a user may replace the gradient coil in the MRI scanner 110 to meet new scanning requirements. For example, in pre-clinical animal experiments, a large-aperture gradient coil may be used for a larger animal, while a small-aperture gradient coil may be used for a smaller animal. Gradient coils with different apertures may be used to accommodate objects of varying sizes. Therefore, in some embodiments, after replacing the gradient coil, it may be useful to determine a type of a currently connected gradient coil, for example, through automatic detection or recognition. Additionally, when the user selects a scanning protocol, a configuration of the scanning protocol is required. Specifically, it is useful to check whether the selected scanning protocol is compatible with the type of the currently connected gradient coil, thereby determining a target scanning protocol that is compatible with the currently connected gradient coil, thus avoiding potential damage to the gradient coil.

In some embodiments, the processing device 140 may process data and/or information obtained from the MRI scanner 110, the at least one terminal 130, and/or the storage device 150, thereby executing the method for configuring a scanning protocol disclosed in the present disclosure. For example, the processing device 140 may retrieve a scanning protocol from the storage device 150 or the at least one terminal 130 to control the MRI scanner 110 to scan a target object according to the selected scanning protocol. As another example, based on the type of the currently connected gradient coil and a user-inputted initial scanning protocol, the processing device 140 may determine the target scanning protocol that is compatible with the currently connected gradient coil. In some embodiments, the processing device 140 may be a single server or a server group. The server group may be centralized or distributed. In some embodiments, the processing device 140 may be local or remote. For example, the processing device 140 may access information and/or data stored in the MRI scanner 110, terminals 130, and/or the storage device 150, or data and/or information obtained by the storage device 150 via the network 120. As another example, the processing device 140 may be directly connected to the MRI scanner 110 (as indicated by the bidirectional dashed arrow connecting the processing device 140 and the MRI scanner 110 in FIG.1), the at least one terminal 130 (as shown by the bidirectional dashed arrow connecting the processing device 140 and the terminals 130 in FIG.1), and/or the storage device 150 to access information and/or data stored or obtained by the respective endpoints. In some embodiments, the processing device 140 may be implemented on a cloud platform. Merely by way of example, the cloud platform may include a private cloud, a public cloud, a hybrid cloud, a community cloud, a distributed cloud, an internal cloud, a multi-layer cloud, or any combination thereof.

The network 120 may include any suitable network facilitating exchange of information and/or data within the MRI system 100. In some embodiments, one or more components (e.g., the MRI scanner 110, the at least one terminal 130, the processing device 140, or the storage device 150) of the MRI system 100 may transmit information and/or data to one or more other components of the MRI system 100 via the network 120. For example, the processing device 140 may obtain the type of the currently connected gradient coil from the MRI scanner 110 via the network 120. As another example, the processing device 140 may obtain a calibration value of a system parameter corresponding to a specific gradient coil type from the storage device 150 via the network 120.

The at least one terminal 130 may include a mobile device 131, a tablet 132, a laptop computer 133, or any combination thereof. In some embodiments, the mobile device 131 may include a wearable device, a smart mobile device, a virtual reality devices, an augmented reality device, or any combination thereof. In some embodiments, the at least one terminal 130 may remotely control the MRI scanner 110 and/or the processing device 140. For example, the at least one terminal 130 may remotely control the MRI scanner 110 and/or the processing device 140 through a wireless connection. In some embodiments, the at least one terminal 130 may receive user-inputted information (such as a scanning protocol) and/or an instruction (such as a scanning command) and transmit the received information and/or instruction to the MRI scanner 110 or the processing device 140 via the network 120. For example, after replacing the gradient coil, the user may input the initial scanning protocol through the at least one terminal 130, and the initial scanning protocol may be sent to the MRI scanner 110 or the processing device 140 for processing and/or use. In some embodiments, the at least one terminal 130 may receive data and/or information from the processing device 140. In some embodiments, the at least one terminal 130 may be part of the processing device 140. In some embodiments, the at least one terminal 130 may be omitted.

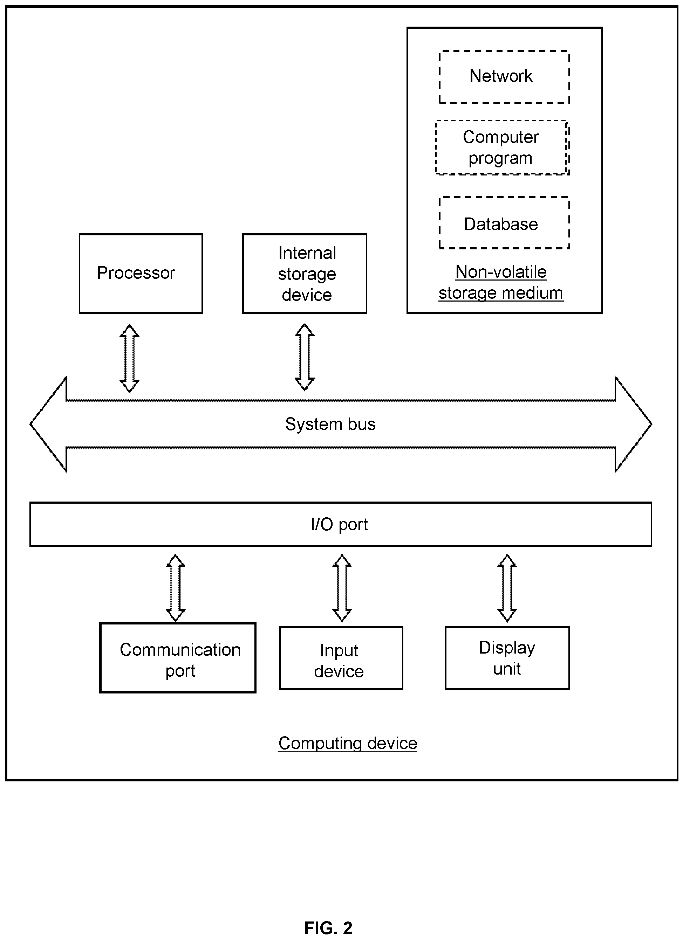

In some embodiments, the at least one terminal 130 and/or the processing device 140 may be implemented on a computing device, which may have one or more components as shown in FIG.2.

The storage device 150 may store data and/or one or more instructions. In some embodiments, the storage device 150 may store data obtained from the MRI scanner 110, the at least one terminal 130, and/or the processing device 140. For example, the storage device 150 may store the calibration value of the system parameter(s), a default protocol, a user-defined protocol, and/or any combination thereof, etc. In some embodiments, the storage device 150 may store data and/or one or more instructions for the processing device 140 to execute exemplary methods provided in the present disclosure. For example, the storage device 150 may store one or more instructions for configuring an MR scanning protocol provided in the present disclosure. As another example, the storage device 150 may store magnetic resonance scanning protocols. In some embodiments, the storage device 150 may include a large-capacity storage device, a removable storage device, a volatile read-write memory, a read-only memory (ROM), or any combination thereof. Exemplary large-capacity storage devices may include a disk, a CD, a solid-state drive, etc. In some embodiments, the storage device 150 may be implemented on a cloud platform. Merely by way of example, the cloud platform may include a private cloud, a public cloud, a hybrid cloud, a community cloud, a distributed cloud, an internal cloud, a multi-layer cloud, or any combination thereof.

In some embodiments, the storage device 150 may be connected to the network 120 to communicate with one or more components (e.g., the MRI scanner 110, the processing device 140, the at least one terminal 130, etc.) of the MRI system 100. One or more components of the MRI system 100 may access data or one or more instructions stored in the storage device 150 via the network 120. In some embodiments, the storage device 150 may directly connect to or communicate with one or more components (e.g., the MRI scanner 110, the processing device 140, the at least one terminal 130, etc.) of the MRI system 100. In some embodiments, the storage device 150 may be part of the processing device 140.

In some embodiments, the MRI system 100 may also include one or more power sources (not shown in FIG. 1) connected to one or more components (e.g., the MRI scanner 110, the processing device 140, the at least one terminal 130, the storage device 150, etc.) of the MRI system 100.

FIG. 2 is an exemplary block diagram of a computing device according to some embodiments of the present disclosure. As shown in FIG.2, the computing device may include a processor, an internal storage device (an internal memory), a non-volatile storage medium, a communication port, an input device, and a display unit connected by a system bus. The processor possesses processing capabilities (e.g., computing and control capabilities). The internal storage device is used to temporarily store operational data from the processor and exchange data with an external storage medium, such as a hard disk (a non-volatile storage medium). The non-volatile storage medium may store an operating system, a computer program (e.g., a computer program for implementing exemplary methods provided in the present disclosure), and a database. The internal storage device may provide a runtime environment for the operating system, the computer program, and the database stored in the non-volatile storage medium. The communication port may be used for wired or wireless communication with an external device, wherein the wireless communication may include WiFi, cellular networks, Near Field Communication (NFC), and/or any combination thereof, etc. The display unit may include one or more of a liquid crystal display, an electronic ink display, and/or any combination thereof, etc. The input device may include a touch layer covering the display unit, a physical button, a trackball, or a touchpad disposed on a casing of the MRI scanner 110. The input device may also include external devices such as a keyboard, a touchpad, a mouse, and/or any combination thereof, etc.

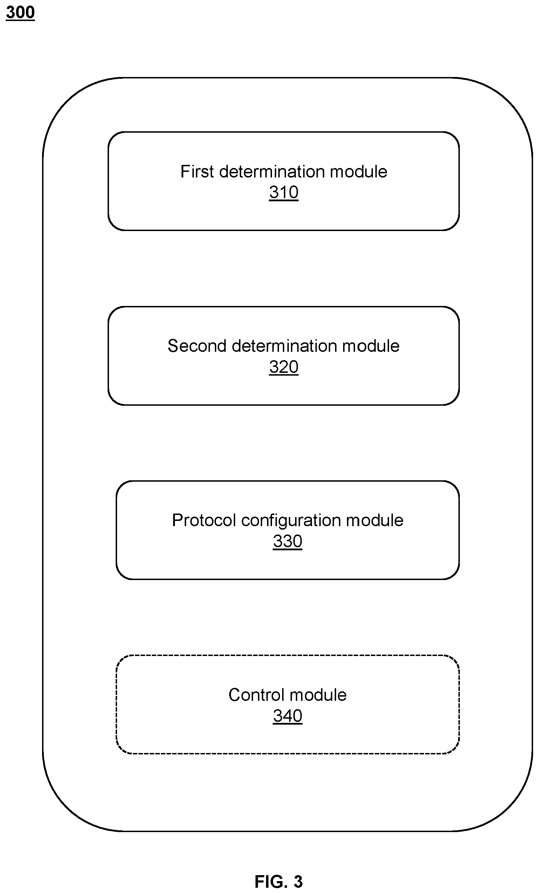

FIG. 3 is an exemplary module diagram of a system for configuring an MR scanning protocol according to some embodiments of the present disclosure. In some embodiments, the system 300 may be implemented on one or more components of the system 100 shown in FIG.1. For example, all modules of the system 300 may be deployed on the MRI scanner 110 or the processing device 140. As another example, the modules in the system 300 may be deployed on two or more of the MRI scanner 110, the at least one terminal 130, the processing device 140, and the storage device 150.

As shown in FIG.3, the system 300 may include a first determination module 310, a second determination module 320, and a protocol configuration module 330.

The first determination module 310 may be configured to determine a first gradient coil type of a first gradient coil currently connected to an MR device. It should be understood that the MR device here may be the MRI scanner 110 shown in FIG.1.

The second determination module 320 may be configured to determine, based on an initial scanning protocol input by a user, at least one second gradient coil type applicable to the initial scanning protocol.

The protocol configuration module 330 may be configured to determine a target scanning protocol based on the first gradient coil type, the at least one second gradient coil type, and the initial scanning protocol.

In some embodiments, the system 300 may also include a control module 340. The control module 340 may be configured to control the MR device to scan a target object according to the target scanning protocol.

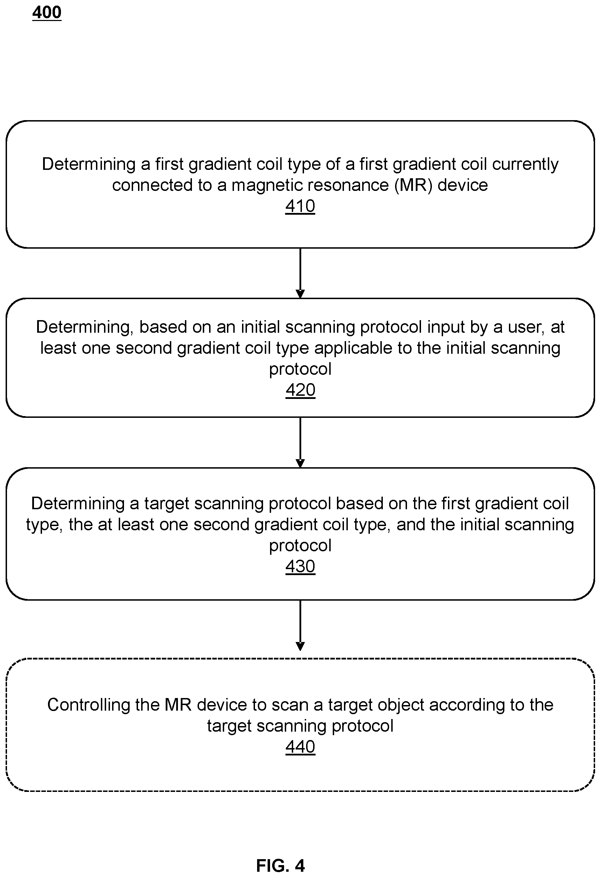

More descriptions regarding the system 300 and the modules thereof may be found in FIG.4 and related descriptions thereof.

It should be noted that the description of the system 300 and the modules thereof above is for convenience of description and does not limit the present disclosure to the scope of the embodiments provided. It may be understood by those skilled in the art that, after understanding the principles of the system, various modules may be arbitrarily combined or form subsystems connected to other modules without departing from these principles. In some embodiments, the second determination module 320 and the protocol configuration module 330 disclosed in FIG.3 may be different modules in a system, or they may be integrated into a single module that implements the functions of the two or more modules mentioned above. For example, the modules may share a storage module, and each module may have its own storage module. Such variations are within the scope of the present disclosure.

FIG. 4 is an exemplary flowchart of a method for configuring an MR scanning protocol according to some embodiments of the present disclosure. In some embodiments, process 400 may be executed by the processing device 140 described in FIG.1 or the system 300 shown in FIG.3.

As shown in FIG.4, process 400 may include the following operations 410-430.

In 410, a first gradient coil type of a first gradient coil currently connected to an MR device may be determined. In some embodiments, operation 410 may be performed by the processing device 140 or the first determination module 310 shown in FIG.3.

As used herein, the gradient coil currently connected to the MR device is referred to as the first gradient coil, and the type of the first gradient coil is referred to as the first gradient coil type.

In some embodiments, the types of gradient coils may be categorized based on aperture sizes of the gradient coils. Merely by way of example, the gradient coils may be categorized into a small aperture gradient coil for scanning a small animal and a large aperture gradient coil for scanning a large animal. However, embodiments of the present disclosure do not specifically limit the categorization manner of gradient coils and may categorize gradient coil types based on practical needs. For example, there may be at least three gradient coil types corresponding to at least three aperture sizes (e.g., small, medium, large). As another example, the gradient coils may be categorized based on other coil parameters. Generally, different types of gradient coils may have different permissible values of scanning parameters.

The first gradient coil type of the first gradient coil currently connected to the MR device may be determined in various feasible ways. In some embodiments, the first gradient coil type of the first gradient coil currently connected to the MR device may be input by a user (e.g., via the at least one terminal 130). In some embodiments, a machine (e.g., the MR device or another machine) may detect (or identify) the first gradient coil type of the currently connected first gradient coil. For example, the first gradient coil may be labeled with its own identification information (e.g., QR code, barcode), which includes the encoding or unique ID of the first gradient coil, used to determine the first gradient coil type. As another example, the identification information may include the first gradient coil type. Thus, the first gradient coil type may be determined by scanning (or photographing) the identification information of the first gradient coil. In some embodiments, the MR device may automatically detect or identify whether the first gradient coil is currently connected, and if the first gradient coil is currently connected, the MR device may further determine the first gradient coil type of the first gradient coil currently connected. For example, a relevant parameter, such as current, voltage, resistance, etc., of the MR device or a detection circuit inside the MR device may be detected after the first gradient coil is connected. Subsequently, based on a relationship between a detected value of the relevant parameter and reference values of the relevant parameter corresponding to different gradient coil types, the first gradient coil type of the currently connected first gradient coil may be determined. For example, the gradient coil type corresponding to the reference value closest to the detected value may be determined as the first gradient coil type.

In 420, at least one second gradient coil type applicable to an initial scanning protocol input by a user may be determined based on the initial scanning protocol. In some embodiments, operation 420 may be performed by the processing device 140 or the second determination module 320 shown in FIG.3.

As used in the present disclosure, a scanning protocol refers to a collection of values or ranges of at least one scanning parameter used in nuclear magnetic resonance (NMR) scanning. The at least one scanning parameter may include parameters such as scanning acquisition time, echo time, echo spacing, echo train length, excitation count, gradient ramp rate, repetition time, and/or any combinations thereof, etc. In some embodiments, the at least one scanning parameter may include one or more system parameters of the MR device. For example, a gradient ramp rate may serve as both a scanning parameter and a system parameter. Some of the one or more system parameters may be physical parameters related to gradient coils. In some embodiments, the at least one scanning parameter may also include one or more non-system parameters. A non-system parameter refers to a parameter that does not belong to the one or more system parameters. It should be noted that certain non-system parameters and system parameters may have a certain correlation, and the non-system parameters may be determined based on the system parameters.

A user-inputted scanning protocol may be referred to as the initial scanning protocol, and a second gradient coil type applicable to the initial scanning protocol may be referred to as the second gradient coil type, which may be distinguished from a gradient coil currently connected to the MR device (i.e., the first gradient coil type). The initial scanning protocol may include an initial parameter range (also referred to as a second parameter range) of each of the at least one scanning parameter set or confirmed by the user. A scanning protocol is considered applicable to a gradient coil type when a parameter range of each scanning parameter included in the scanning protocol falls within a permissible range of the gradient coil type. Merely by way of example, the parameter range of each scanning parameter included in a scanning protocol applicable to a large aperture gradient coil falls within the permissible range of the large aperture gradient coil, and similarly, the parameter range of each scanning parameter included in a scanning protocol applicable to a small aperture gradient coil falls within the permissible range of the small aperture gradient coil. By delivering a scanning protocol using a gradient coil of the gradient coil type that matches the scanning protocol, the lifespan of the gradient coil can be extended and damage caused by improper use can be avoided.

In some embodiments, the initial scanning protocol may indicate at least one second gradient coil type to which the initial scanning protocol is applicable. For example, the initial scanning protocol may include a specific protocol field indicating the second gradient coil type to which the initial scanning protocol is applicable. As another example, a relationship between the values or ranges of scanning parameters and the corresponding gradient coil types may be pre-stored, so that the at least one second gradient coil type can be determined based on initial values or ranges of scanning parameters in the initial scanning protocol.

In some embodiments, the user-inputted initial scanning protocol may be a default protocol in a default protocol package or a custom protocol in a custom protocol package. The default protocol in the default protocol package may be set by the manufacturer of the gradient coil. The custom protocol in the custom protocol package may be set by the user.

Typically, when the user purchases a gradient coil belonging to a certain gradient coil type from the manufacturer, the manufacturer provides the user with the default protocol package corresponding to the gradient coil type. The default protocol package may include a plurality of default protocols applicable to the gradient coil type, and different protocols within the package may serve different purposes, such as scanning different parts of the body. Each of the plurality of default protocols may include default range(s) for the at least one scanning parameter, such as default ranges for parameters like acquisition time, echo time, echo spacing, echo train length, excitation count, etc. After connecting a gradient coil of a new type to the MR device, the MR device may install the default protocol package corresponding to that new gradient coil type. The default protocol package may be stored locally, such as in the storage device 150 shown in FIG.1. Each default protocol package may have a corresponding name (e.g., "Large Aperture Gradient Coil" and "Small Aperture Gradient Coil"), and each default protocol within the default protocol package may also have a corresponding name (e.g., named directly based on a scanned region). Names of installed/stored default protocol packages and internal protocol names thereof may be displayed on a display interface, such as the display of the at least one terminal 130 shown in FIG. 1, for user differentiation and selection. In other words, the user may choose a default protocol as the initial scanning protocol on the display interface.

In some embodiments, when installing default protocol packages on the MR device, the installation of default protocol packages corresponding to different gradient coil types may be controlled through license configuration or service configuration, facilitating more fine-tuned management of usage authorizations for default protocol packages. Taking license configuration to control the installation of default protocol packages as an example, assuming the user purchases a large aperture gradient coil from the manufacturer, the license only authorizes the user to use the default protocol package corresponding to the large aperture gradient coil. The MR device may install the default protocol package corresponding to the large aperture gradient coil under the authorization of the license.

Optionally, a process for configuring the installation of a default protocol package through license configuration may include the following operations: a corresponding license may be generated based on a configuration list of the gradient coil purchased by the user (which may include the gradient coil type to which the purchased gradient coil belongs, e.g., large aperture gradient coil, small aperture gradient coil); when installing the protocol package, the MR device may interpret the license, check the validity period of the license, and if the license is within the valid period, the MR device may further determine whether the default protocol package corresponding to the gradient coil type is authorized (i.e., whether the usage permission for the protocol package in the license is authorized). If the usage permission for the protocol package is authorized, the MR device may update authorization attribute information of the protocol package stored in the database corresponding to the gradient coil type and install the authorized protocol package. After the MR device starts, the installed protocol package may be displayed on the display interface of the MR device through a protocol management module in the MR device.

In some embodiments, the MR device may also provide the user with a convenient custom protocol function, allowing the user to add custom protocol packages corresponding to different gradient coil types. In the custom protocol package, the user may add at least one custom protocol, flexibly setting scanning parameters and corresponding parameter ranges in different protocols to enable the MR device to acquire magnetic resonance images that meet various needs based on custom protocols. After the user adds the custom protocol packages, the MR device may save the custom protocol packages locally. The MR device may also display the user-added custom protocol packages on the display interface, with each custom protocol package having a corresponding name. Each protocol within the protocol package may also have a corresponding name, facilitating user differentiation and selection.

In some embodiments, for each installed protocol package, the correspondence between the protocol package and a gradient coil type may be pre-stored. The gradient coil type corresponding to each protocol package may be represented by a gradient coil attribute parameter. Based on this, the second determination module 320 may first determine the protocol package to which the user-input initial scanning protocol belongs, and then determine the gradient coil type corresponding to that protocol package as the first gradient coil type. For example, if it is determined that the user-input initial scanning protocol belongs to the protocol package of the large aperture gradient coil, the second determination module 320 may determine that the second gradient coil type used in the initial scanning protocol is the large aperture gradient coil.

In 430, a target scanning protocol may be determined based on the first gradient coil type, the at least one second gradient coil type, and the initial scanning protocol. In some embodiments, operation 430 may be performed by the processing device 140 or the protocol configuration module 330 shown in FIG.3.

The target scanning protocol refers to a scanning protocol to be used during the scanning process of the MR device. As mentioned above, different types of gradient coils may have different permissible ranges of scanning parameters. When generating the target scanning protocol, it is necessary to consider whether each scanning parameter in the user-input initial scanning protocol is within the permissible range of the first gradient coil, thereby generating the target scanning protocol that is compatible with the first gradient coil and meets user requirements.

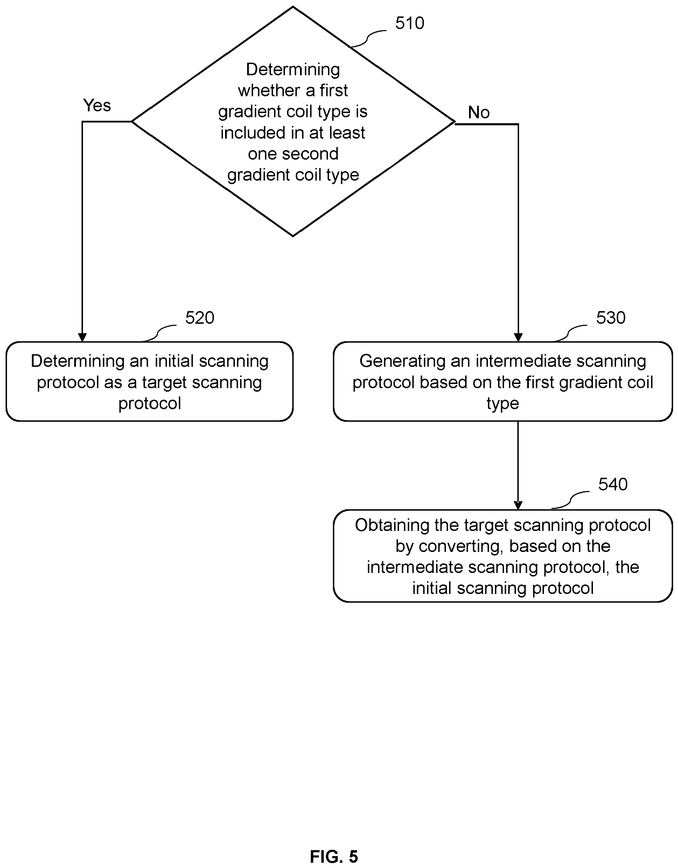

In some embodiments, operation 430 may be performed through a process shown in FIG.5. As shown in FIG.5, the process includes the following operations 510-540.

In 510, it may be determined whether the first gradient coil type is included in the at least one second gradient coil type. When the first gradient coil type is included in the at least one second gradient coil type, it indicates that the user-input initial scanning protocol is compatible with the currently connected first gradient coil (i.e., applicable to the first gradient coil type). Accordingly, operation 520 may be executed. In operation 520, the initial scanning protocol may be directly determined as the target scanning protocol.

When the first gradient coil type is not included in the at least one second gradient coil type, it indicates that the user-input initial scanning protocol is not compatible with the currently connected first gradient coil (i.e., not applicable to the first gradient coil type). Accordingly, a protocol conversion may be performed on the initial scanning protocol to obtain the target scanning protocol. In some embodiments, the protocol conversion may be achieved by performing operations 530 and 540.

In 530, an intermediate scanning protocol may be generated based on the first gradient coil type. The intermediate scanning protocol may be a scanning protocol compatible with the first gradient coil type. For example, the intermediate scanning protocol may include a first parameter range of each of the at least one scanning parameter, and the first parameter range is within the permissible range of the first gradient coil.

In some embodiments, the intermediate scanning protocol may be generated based on a reference protocol (e.g., a default protocol or a user-defined protocol) corresponding to the first gradient coil type. Specifically, the protocol configuration module 330 may obtain at least one reference protocol corresponding to the first gradient coil type, where the at least one reference protocol includes a reference range of each of the at least one scanning parameter. Subsequently, the protocol configuration module 330 may determine the first parameter range of each of the at least one scanning parameter based on the reference range of each of at least one scanning parameter. In one example, a specific protocol from the default/custom protocol package corresponding to the first gradient coil type may be directly used as the intermediate scanning protocol. Here, the specific protocol refers to a protocol with a same purpose as the user-input initial scanning protocol. For example, when different protocols in the protocol package are named based on a scanned body part, the specific protocol may refer to a protocol with a same name as the user-input initial scanning protocol (e.g., a cardiac scanning protocol). In another example, a parameter range (i.e., the first parameter range) of a scanning parameter in the intermediate scanning protocol may be obtained by taking the union of the parameter ranges (i.e., the reference ranges) of the scanning parameter in a plurality of protocols with a same purpose (i.e., the same purpose as the user-input initial scanning protocol). For example, if the user-input initial scanning protocol is the cardiac scanning protocol, and parameter A has a reference range of [15.1, 30.2] in the cardiac scanning protocol in the default protocol package and a reference range of [14.9, 30.4] in the cardiac scanning protocol in the user-defined protocol package, the first parameter range of parameter A in the intermediate scanning protocol may be set as the union of [15.1, 30.2] and [14.9, 30.4], which is [14.9, 30.4]. In yet another example, for a scanning parameter, endpoint values of the corresponding parameter ranges in scanning protocols with a same purpose (i.e., the same purpose as the user-input initial scanning protocol) may be averaged to obtain the first parameter range of the scanning parameter in the intermediate scanning protocol. Using the previous example, if the reference ranges for parameter A are [15.1, 30.2] and [14.9, 30.4], the first parameter range of parameter A in the intermediate scanning protocol may be set as [15.0, 30.3].

In some embodiments, due to the correlation between system parameters related to gradient coils and some scanning parameters, the protocol configuration module 330 may first determine calibration value(s) of the system parameter(s) corresponding to the first gradient coil type. Then, based on the calibration value(s) of the system parameter(s), the protocol configuration module 330 may determine the first parameter range of each of the at least one scanning parameter included in the intermediate scanning protocol. For ease of description, the calibration value of the system parameter corresponding to the first gradient coil type is referred to as a target calibration value. Merely by way of example, the target calibration value for the gradient ramp rate (which is also a scanning parameter) may be used as a center value of the first parameter range of the gradient ramp rate in the intermediate scanning protocol. The first parameter range of the gradient ramp rate may then be generated based on a preset range width. As another example, the target calibration value of the gradient ramp rate may be obtained, and based on the target calibration value, the first parameter ranges of repetition time and/or echo time may be determined. In some embodiments, in the absence of a pre-stored default protocol/user-defined protocol corresponding to the first gradient coil type, the protocol configuration module 330 may generate the intermediate scanning protocol based on the calibration value(s) of the system parameter(s). In some embodiments, the target calibration value may be predetermined and stored in a storage device (e.g., the storage device 150), and the protocol configuration module 330 may retrieve the target calibration value from the storage device. More descriptions regarding the system parameters may be found in other parts of the present disclosure, such as the descriptions on the relationship between the scanning parameter and the system parameter in operation 420, and is not reiterated here.

In 540, the initial scanning protocol may be converted into the target scanning protocol based on the intermediate scanning protocol. In some embodiments, the target scanning protocol may be obtained by taking an intersection of parameter ranges included in the intermediate scanning protocol and the initial scanning protocol. Specifically, the intermediate scanning protocol includes the first parameter range of each of the at least one scanning parameter, and the initial scanning protocol includes the second parameter range of each of the at least one scanning parameter. For each of the at least one scanning parameter, the protocol configuration module 330 may determine an intersection between the first parameter range and the second parameter range of the scanning parameter. Subsequently, the protocol configuration module 330 may update the initial scanning protocol based on the range intersection of the at least one scanning parameter, thereby obtaining the target scanning protocol. Understandably, the at least one scanning parameter here refers to a same scanning parameter in both the intermediate scanning protocol and the initial scanning protocol.

For ease of understanding, the following example is provided: the intermediate scanning protocol includes a first parameter range of scanning parameter A, a first parameter range of scanning parameter B, a first parameter range of scanning parameter C, and a first parameter range of scanning parameter D; the initial scanning protocol includes a second parameter range of scanning parameter A and a second parameter range of scanning parameter B. Therefore, the intersection of the first and second parameter ranges of scanning parameter A may be designated as the target range of scanning parameter A in the target scanning protocol. Similarly, the intersection of the first and second parameter ranges of scanning parameter B may be designated as the target range for scanning parameter B in the target scanning protocol. In some embodiments, if the initial scanning protocol includes a second parameter range of a scanning parameter, and the intermediate scanning protocol does not include the scanning parameter, the second parameter range of the scanning parameter may be directly retained in the target scanning protocol.

In accordance with some embodiments of the present disclosure, the protocol configuration module 330 may first determine whether the first gradient coil type is included in the at least one second gradient coil type. On the basis of a result of the determination, the target scanning protocol may be obtained based on the initial scanning protocol. Thus, when changing the gradient coil, adaptive protocol configuration may be achieved without the assistance of a professional, saving labor costs, and reducing the waiting time for subsequent scans. Moreover, using the method for configuring the MR scanning protocol disclosed in the present disclosure, the generated target scanning protocol may be adapted to the currently connected first gradient coil, avoiding damage to the first gradient coil, and meeting the scanning needs of the user.

In some embodiments, process 400 may also include operation 440.

In 440, the MR device may be controlled to scan a target object according to the target scanning protocol. In some embodiments, operation 440 may be executed by the control module 340 as shown in FIG. 3.

For example, the control module 340 may send one or more control commands to the MR device based on the target scanning protocol to instruct the MR device to scan the target object according to the target scanning protocol. In some embodiments, the MR device may be controlled to scan the target object according to the target scanning protocol by an external device (e.g., the processing device 140). For example, other devices may control the MR device to scan the target object according to the target scanning protocol by conveying one or more instructions. In some embodiments, the MR device may obtain the target scanning protocol and autonomously scan the target object according to the target scanning protocol.

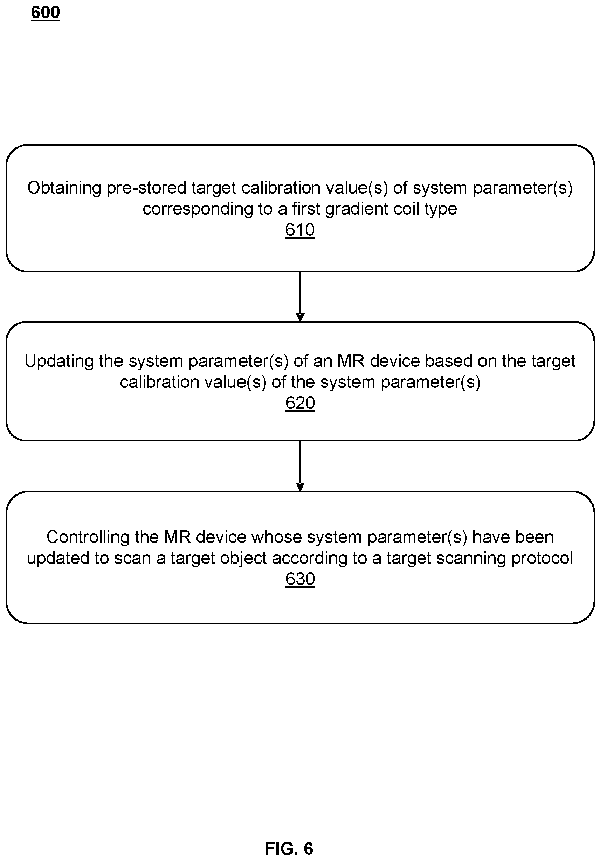

In some embodiments, operation 440 may be implemented using process 600 shown in FIG. 6. As illustrated in FIG. 6, process 600 may include the following operations 610-630.

In 610, pre-stored calibration value(s) (i.e., the target calibration value(s)) of one or more system parameters corresponding to a first gradient coil type may be obtained.

In some embodiments, the one or more system parameters of the MR device may include relevant physical parameters of the gradient coil, such as a size of an eddy current generated by the gradient coil, a gradient ramp rate, etc.

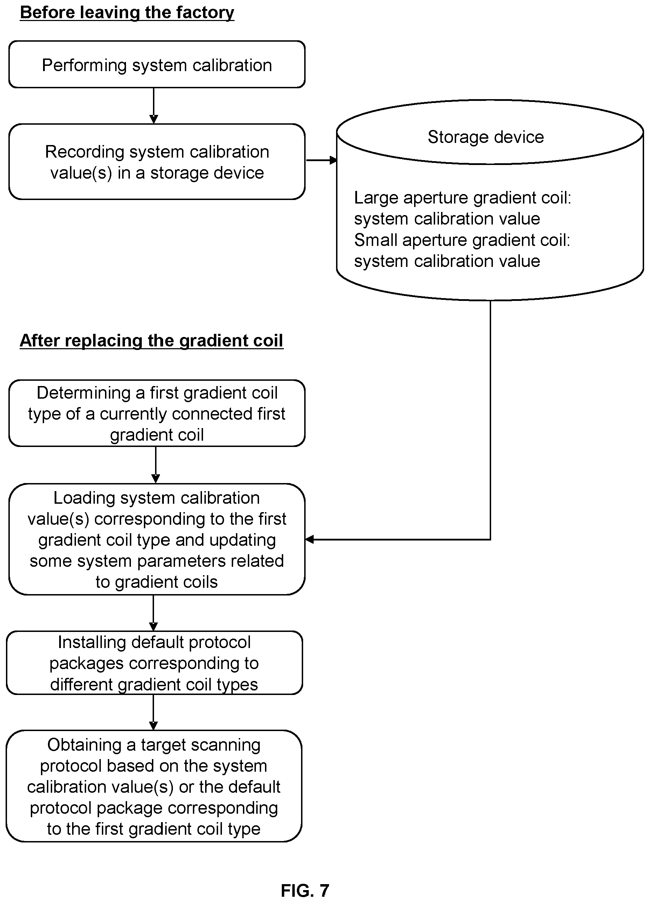

In some embodiments, the target calibration value(s) may be determined by performing system calibration on a reference MR device installed with a reference first gradient coil. The reference first gradient coil may be the currently connected first gradient coil described in operation 410 or another gradient coil belonging to the first gradient coil type. The reference MR device may be an MR device described in operation 410 or another MR device with the same model as the MR device. For example, a manufacturer may perform a system calibration process on the reference MR device with the same model as the MR device used by the user before the first gradient coil leaves the factory, to obtain the target calibration value(s) corresponding to the first coil type. Subsequently, after the user purchases the first gradient coil, the manufacturer may provide the target calibration value(s) to the user. The user may pre-store the target calibration value(s) in the MR device or storage device. Therefore, when the MR device connects to the first gradient coil, the pre-stored target calibration value(s) may be obtained and the one or more system parameters may be updated based on the pre-stored target calibration value(s), eliminating the need for system calibration. In some embodiments, the target calibration value(s) corresponding to the system parameter(s) of different types of gradient coils purchased by the user may be separately stored according to the gradient coil types. For example, as shown in FIG. 7, the calibration value(s) of the system parameter(s) for small aperture gradient coils and large aperture gradient coils may be stored separately (e.g., in two comparison tables).

In 620, the one or more system parameters of the MR device may be updated based on the target calibration value(s).

In some embodiments, the system calibration in operation 620 refers to updating the one or more system parameters to be consistent with the target calibration value(s). In some embodiments, within an allowed error range, the one or more system parameters may be adjusted to approximate the corresponding target calibration value(s). It is understood that, in addition to physical parameters related to gradient coils, the one or more system parameters may also include other parameters; and the system calibration and system parameter updating only involve the physical parameters related to gradient coils.

In 630, the MR device whose system parameter(s) have been updated may be controlled to scan the target object according to the target scanning protocol.

By pre-storing calibration value(s) of system parameter(s) that are adapted (correspond) to the gradient coil type, system calibration may be avoided, reducing manual costs and improving system efficiency.

FIG. 7 is a schematic diagram of a workflow of an MR device according to some embodiments of the present disclosure.

As shown in FIG. 7, before leaving the factory, system calibration may be performed for different gradient coil types (e.g., large aperture gradient coils and small aperture gradient coils). Subsequently, the calibration value(s) of system parameters corresponding to different gradient coil types (referred to as system calibration value(s)) may be pre-stored in a storage device. The storage device may be an external or internal storage device of the MR device used by a user. Similarly, default protocol packages corresponding to different gradient coil types provided by the manufacturer may be pre-stored in the storage device (not shown in the figure). Here, the different gradient coil types refer to different types of gradient coils to which different gradient coils purchased by the user from the manufacturer belong. For example, the user may purchase two types of gradient coils, a large aperture gradient coil and a small aperture gradient coil, from a manufacturer. Therefore, when the user replaces a connected gradient coil of the MR device, the MR device may determine a first gradient coil type currently connected to the MR device, load the system calibration value(s) corresponding to the first gradient coil type from the storage device to update some system parameters related to gradient coils, and install default protocol packages corresponding to the different gradient coil types (or install the default protocol package corresponding to the first gradient coil type). Subsequently, the MR device may obtain a target scanning protocol based on the system calibration value(s) or the default protocol package corresponding to the first gradient coil type. More descriptions regarding the protocol configuration (conversion) may be found in FIG.4 and related descriptions thereof.

It should be noted that the above description of the process is only for illustration and explanation and does not limit the scope of the present disclosure. For those skilled in the art, various modifications and changes may be made to the process under the guidance of the present disclosure. However, these modifications and changes are still within the scope of the present disclosure. For example, in some embodiments, process 400 may not include operation 440.

The basic concepts have been described above, and it is apparent that to a person skilled in the art, the above detailed disclosure is intended as an example only and does not constitute a limitation of the present disclosure. Although not expressly stated herein, various modifications, improvements, and amendments may be made to the present disclosure by those skilled in the art. Such modifications, improvements, and amendments are suggested in the present disclosure, so such modifications, improvements, and amendments remain within the spirit and scope of the exemplary embodiments of the present disclosure.

Also, the present disclosure uses specific words to describe the embodiments of the present disclosure. For example, "an embodiment," "one embodiment," and/or "some embodiments" are meant to refer to a certain feature, structure, or characteristic associated with at least one embodiment of the present disclosure. Accordingly, it should be emphasized and noted that "an embodiment" or "one embodiment" or "an alternative embodiment" mentioned two or more times in different places in the present disclosure do not necessarily refer to the same embodiment. Furthermore, certain features, structures, or characteristics in one or more embodiments of the present disclosure may be suitably combined.

Furthermore, unless expressly stated in the claims, the order of processing elements and sequences, the use of numerical letters, or the use of other names described herein are not intended to limit the order of the processes and methods of the present disclosure. Although a number of embodiments of the present disclosure currently considered useful are discussed in the above disclosure by way of various examples, it should be understood that such details serve illustrative purposes only, and that additional claims are not limited to the disclosed embodiments; rather, the claims are intended to cover all amendments and equivalent combinations that are consistent with the substance and scope of the embodiments of the present disclosure. For example, although the implementation of various components described above may be embodied in a hardware device, it may also be implemented as a software only solution, e.g., an installation on an existing server or mobile device.

Similarly, it should be noted that in order to simplify the presentation of the present disclosure, and thus aid in the understanding of one or more embodiments of the present disclosure, the preceding description of embodiments of the present disclosure sometimes combines multiple features into a single embodiment, accompanying drawings, or description thereof. However, this way of disclosure does not imply that the subject matter of the present disclosure requires more features than those mentioned in the claims. Rather, claimed subject matter may lie in less than all features of a single foregoing disclosed embodiment.

In some embodiments, numeric values describing the composition and quantity of attributes are used in the description. It should be understood that such numeric values used for describing embodiments may be modified with qualifying terms such as "about," "approximately," or "generally." Unless otherwise stated, "about," "approximately," or "generally" indicates that a variation of ±20% is permitted in the described numbers. Accordingly, in some embodiments, the numerical parameters used in the disclosure and claims are approximations, which can change depending on the desired characteristics of the individual embodiment. In some embodiments, the numerical parameters should take into account a specified number of valid digits and employ a general manner of bit retention. Although the numerical ranges and parameters used in some embodiments of the present disclosure to confirm the breadth of the range are approximations, in specific embodiments, such numerical values are set as precisely as practicable.

With respect to each of the patents, patent applications, publications of patent applications, and other material, such as articles, books, specifications, publications, documents and the like, cited in the present disclosure, the entire contents thereof are hereby incorporated herein by reference. Application history documents that are inconsistent with the contents of the present disclosure or that create conflicts are excluded, as are documents (currently or hereafter appended to the present disclosure) that limit the broadest scope of the claims of the present disclosure. It should be noted that in the event of any inconsistency or conflict between the descriptions, definitions, and/or use of terminology in the materials appended to the present disclosure and the contents described herein, the descriptions, definitions, and/or use of terminology in the present disclosure shall prevail.

Finally, it should be understood that the embodiments described in the present disclosure are used only to illustrate the principles of the embodiments of the present disclosure. Other deformations may also fall within the scope of the present disclosure. Therefore, by way of example and not limitation, alternative configurations of the embodiments disclosed in the present disclosure may be considered consistent with the teachings of the present disclosure. Accordingly, the embodiments described in the present disclosure are not limited to the explicitly introduced and described embodiments in the present disclosure.

## Claims

1. A method for configuring a magnetic resonance (MR) scanning protocol, comprising:
determining a first gradient coil type of a first gradient coil currently connected to an MR device;
determining, based on an initial scanning protocol input by a user, at least one second gradient coil type applicable to the initial scanning protocol; and
determining a target scanning protocol based on the first gradient coil type, the at least one second gradient coil type, and the initial scanning protocol.

2. The method of claim 1, wherein the determining a target scanning protocol based on the first gradient coil type, the at least one second gradient coil type, and the initial scanning protocol includes:
determining whether the first gradient coil type is included in the at least one second gradient coil type; and
in response to determining that the first gradient coil type is included in the at least one second gradient coil type, determining the initial scanning protocol as the target scanning protocol.

3. The method of claim 1, wherein the determining a target scanning protocol based on the first gradient coil type, the at least one second gradient coil type, and the initial scanning protocol includes:
determining whether the first gradient coil type is included in the at least one second gradient coil type;
in response to determining that the first gradient coil type is not included in the at least one second gradient coil type, generating an intermediate scanning protocol based on the first gradient coil type; and
obtaining the target scanning protocol by converting, based on the intermediate scanning protocol, the initial scanning protocol.

4. The method of claim 3, wherein the intermediate scanning protocol includes a first parameter range of each of at least one scanning parameter, and the generating an intermediate scanning protocol based on the first gradient coil type includes:
determining a calibration value of a system parameter corresponding to the first gradient coil type; and
generating the intermediate scanning protocol by determining, based on the calibration value of the system parameter, the first parameter range of each of the at least one scanning parameter.

5. The method of claim 3, wherein the intermediate scanning protocol includes a first parameter range of each of at least one scanning parameter, and the generating an intermediate scanning protocol based on the first gradient coil type includes:
obtaining at least one reference protocol corresponding to the first gradient coil type, the at least one reference protocol including a reference range of each of the at least one scanning parameter; and
generating the intermediate scanning protocol by determining, based on the reference range of each of the at least one scanning parameter, the first parameter range of each of the at least one scanning parameter.

6. The method of claim 3, wherein the intermediate scanning protocol includes a first parameter range of each of at least one scanning parameter, the initial scanning protocol includes a second parameter range of each of the at least one scanning parameter, and the obtaining the target scanning protocol by converting, based on the intermediate scanning protocol, the initial scanning protocol includes:
for each of the at least one scanning parameter, determining an intersection range between the first parameter range and the second parameter range of the scanning parameter; and
obtaining the target scanning protocol by updating, based on at least one intersection range of the at least one scanning parameter, the initial scanning protocol.

7. The method of claim 1, further comprising:
controlling the MR device to scan a target object according to the target scanning protocol.

8. The method of claim 7, wherein the controlling the MR device to scan a target object according to the target scanning protocol includes:
obtaining a pre-stored calibration value of a system parameter corresponding to the first gradient coil type;
updating the system parameter of the MR device based on the calibration value of the system parameter; and
controlling the MR device whose system parameter has been updated to scan the target object according to the target scanning protocol.

9. A system for configuring a magnetic resonance (MR) scanning protocol, comprising:
at least one storage device configured to store one or more instructions for configuring the MR scanning protocol;
at least one processor in communication with the at least one storage device, wherein, when executing the one or more instructions, the at least one processor is configured to direct the system to perform operations including:
determining a first gradient coil type of a first gradient coil currently connected to an MR device;
determining, based on an initial scanning protocol input by a user, at least one second gradient coil type applicable to the initial scanning protocol; and
determining a target scanning protocol based on the first gradient coil type, the at least one second gradient coil type, and the initial scanning protocol.

10. The system of claim 9, wherein the determining a target scanning protocol based on the first gradient coil type, the at least one second gradient coil type, and the initial scanning protocol includes:
determining whether the first gradient coil type is included in the at least one second gradient coil type; and
in response to determining that the first gradient coil type is included in the at least one second gradient coil type, determining the initial scanning protocol as the target scanning protocol.

11. The system of claim 9, wherein the determining a target scanning protocol based on the first gradient coil type, the at least one second gradient coil type, and the initial scanning protocol includes:
determining whether the first gradient coil type is included in the at least one second gradient coil type;
in response to determining that the first gradient coil type is not included in the at least one second gradient coil type, generating an intermediate scanning protocol based on the first gradient coil type; and
obtaining the target scanning protocol by converting, based on the intermediate scanning protocol, the initial scanning protocol.

12. The system of claim 11, wherein the intermediate scanning protocol includes a first parameter range of each of at least one scanning parameter, and the generating an intermediate scanning protocol based on the first gradient coil type includes:
determining a calibration value of a system parameter corresponding to the first gradient coil type; and
generating the intermediate scanning protocol by determining, based on the calibration value of the system parameter, the first parameter range of each of the at least one scanning parameter.

13. The system of claim 11, wherein the intermediate scanning protocol includes a first parameter range of each of at least one scanning parameter, and the generating an intermediate scanning protocol based on the first gradient coil type includes:
obtaining at least one reference protocol corresponding to the first gradient coil type, the at least one reference protocol including a reference range of each of the at least one scanning parameter; and
generating the intermediate scanning protocol by determining, based on the reference range of each of the at least one scanning parameter, the first parameter range of each of the at least one scanning parameter.

14. The system of claim 11, wherein the intermediate scanning protocol includes a first parameter range of each of at least one scanning parameter, the initial scanning protocol includes a second parameter range of each of the at least one scanning parameter, and the obtaining the target scanning protocol by converting, based on the intermediate scanning protocol, the initial scanning protocol includes:
for each of the at least one scanning parameter, determining an intersection range between the first parameter range and the second parameter range of the scanning parameter; and
obtaining the target scanning protocol by updating, based on at least one intersection range of the at least one scanning parameter, the initial scanning protocol.

15. The system of claim 9, further comprising:
controlling the MR device to scan a target object according to the target scanning protocol.

16. The system of claim 15, wherein the controlling the MR device to scan a target object according to the target scanning protocol includes:
obtaining a pre-stored calibration value of a system parameter corresponding to the first gradient coil type;
updating the system parameter of the MR device based on the calibration value of the system parameter; and
controlling the MR device whose system parameter has been updated to scan the target object according to the target scanning protocol.

17. A non-transitory computer-readable storage medium, storing one or more computer instructions, wherein when the one or more instructions are read from the storage medium, a computer executes a method for configuring a magnetic resonance (MR) scanning protocol, the method comprising:
determining a first gradient coil type of a first gradient coil currently connected to an MR device;
determining, based on an initial scanning protocol input by a user, at least one second gradient coil type applicable to the initial scanning protocol; and
determining a target scanning protocol based on the first gradient coil type, the at least one second gradient coil type, and the initial scanning protocol.

18. The non-transitory computer-readable storage medium of claim 17, wherein the determining a target scanning protocol based on the first gradient coil type, the at least one second gradient coil type, and the initial scanning protocol includes:
determining whether the first gradient coil type is included in the at least one second gradient coil type; and
in response to determining that the first gradient coil type is included in the at least one second gradient coil type, determining the initial scanning protocol as the target scanning protocol.

19. The non-transitory computer-readable storage medium of claim 17, wherein the determining a target scanning protocol based on the first gradient coil type, the at least one second gradient coil type, and the initial scanning protocol includes:
determining whether the first gradient coil type is included in the at least one second gradient coil type;
in response to determining that the first gradient coil type is not included in the at least one second gradient coil type, generating an intermediate scanning protocol based on the first gradient coil type; and
obtaining the target scanning protocol by converting, based on the intermediate scanning protocol, the initial scanning protocol.

20. The non-transitory computer-readable storage medium of claim 3, wherein the intermediate scanning protocol includes a first parameter range of each of at least one scanning parameter, and the generating an intermediate scanning protocol based on the first gradient coil type includes:
determining a calibration value of a system parameter corresponding to the first gradient coil type; and
generating the intermediate scanning protocol by determining, based on the calibration value of the system parameter, the first parameter range of each of the at least one scanning parameter.
